(19) Europäisches Patentamt
European Patent Office
Office européen des brevets

(11) **EP 1 614 004 B1**

## (12) EUROPEAN PATENT SPECIFICATION

(45) Date of publication and mention
of the grant of the patent:
**31.10.2012 Bulletin 2012/44**

(21) Application number: **04758238.2**

(22) Date of filing: **24.03.2004**

(51) Int Cl.:
**B44C 1/22** (2006.01)     **G03F 7/00** (2006.01)

(86) International application number:
**PCT/US2004/008920**

(87) International publication number:
**WO 2004/088414 (14.10.2004 Gazette 2004/42)**

(54) **POSITIVE TONE BI-LAYER IMPRINT LITHOGRAPHY METHOD AND COMPOSITIONS THEREFOR**

POSITIV-TONUNGS-ZWEISCHICHT-AUFDRUCKLITHOGRAPHIEVERFAHREN UND ZUSAMMENSETZUNGEN DAFÜR

PROCEDE ET COMPOSITIONS DE LITHOGRAPHIE PAR IMPRESSION BICOUCHE ET TON POSITIF

(84) Designated Contracting States:
**AT BE BG CH CY CZ DE DK EE ES FI FR GB GR HU IE IT LI LU MC NL PL PT RO SE SI SK TR**

(30) Priority: **25.03.2003 US 396615**
**27.02.2004 US 789319**

(43) Date of publication of application:
**11.01.2006 Bulletin 2006/02**

(73) Proprietor: **MOLECULAR IMPRINTS, INC.**
**Austin, TX 78758-3605 (US)**

(72) Inventors:
• **SREENIVASAN, Sidlgata, V.**
**Austin, TX 78750-3858 (US)**
• **XU, Frank, Y.**
**Round Rock, Texas 78664 (US)**
• **MILLER, Michael, N.**
**Austin, TX 78759-3711 (US)**
• **WATTS, Michael, P.C.**
**Austin, TX 78730-2709 (US)**

(74) Representative: **Ponzellini, Gianmarco et al**
**Ponzellini, Gioia e Associati S.r.l.**
**Via Mascheroni, 31**
**20145 Milano (IT)**

(56) References cited:
**US-A- 4 517 337         US-A1- 2002 026 183**
**US-A1- 2002 036 183    US-A1- 2004 202 872**

• **BENDER M ET AL: "Multiple imprinting in UV-based nanoimprint lithography: related material issues" MICROELECTRONIC ENGINEERING, ELSEVIER PUBLISHERS BV., AMSTERDAM, NL, vol. 61-62, 1 July 2002 (2002-07-01), pages 407-413, XP004360562 ISSN: 0167-9317**
• **"OPTICAL AND SUB-OPTICAL IMAGING TECHNIQUE USING OPTICAL IMAGING" IBM TECHNICAL DISCLOSURE BULLETIN, IBM CORP. NEW YORK, US, vol. 32, no. 5B, 1 October 1989 (1989-10-01), page 435/436, XP000049204 ISSN: 0018-8689**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

## Description

BACKGROUND OF THE INVENTION

The field of invention relates generally to micro-fabrication of structures. More particularly, the present invention is directed to patterning substrates in furtherance of the formation of structures.

Micro-fabrication involves the fabrication of very small structures, e.g., having features on the order of micro-meters or smaller. One area in which micro-fabrication has had a sizeable impact is in the processing of integrated circuits. As the semiconductor processing industry continues to strive for larger production yields while increasing the circuits per unit area formed on a substrate, micro-fabrication becomes increasingly important. Micro-fabrication provides greater process control while allowing increased reduction of the minimum feature dimension of the structures formed. Other areas of development in which micro-fabrication has been employed include biotechnology, optical technology, mechanical systems and the like.

An exemplary micro-fabrication technique is shown in United States patent number 6,334,960 to Willson et al. Willson et al. disclose a method of forming a relief image in a structure. The method includes providing a substrate having a transfer layer. The transfer layer is covered with a polymerizable fluid composition. An imprint device makes mechanical contact with the polymerizable fluid. The imprint device includes a relief structure formed from lands and grooves. The polymerizable fluid composition fills the relief structure, with the thickness of the polymerizable fluid in superimposition with the lands defining a residual thickness. The polymerizable fluid composition is then subjected to conditions to solidify and polymerize the same, forming a solidified polymeric material on the transfer layer that contains a relief structure complimentary to that of the imprint device. The imprint device is then separated from the solid polymeric material such that a replica of the relief structure in the imprint device is formed in the solidified polymeric material. The transfer layer and the solidified polymeric material are subjected to an environment to selectively etch the transfer layer relative to the solidified polymeric material such that a relief image is formed in the transfer layer. Thereafter, conventional etching processes may be employed to transfer the pattern of the relief structure into the substrate.

It is desired to minimize dimensional variations between the pattern recorded in the polymeric material from the pattern transferred into the substrate, referred to as transfer distortions. To that end, many attempts have been made to advance the micro-fabrication technique of Willson et al. For example, it has been desired to minimize the residual thickness of the solidified polymeric material. The thinner the residual thickness, the greater reduction in transfer distortions. The residual thickness of the solidified polymeric material is proportional to the residual thickness of the polymerizable fluid. However, the rate at which the polymerizable fluid fills the relief structure is inversely proportional to the cube of the residual thickness of polymerizable fluid. It is manifest that minimizing the transfer distortions increases the time required to record the pattern in the substrate. Thus, a tradeoff exists between throughput and minimization of transfer distortions.

US 2002036183 discloses a method of forming a pattern, which comprises forming a first resist film on a surface of a substrate; patterning the first resist film to form a first resist pattern; and forming a covering layer containing silicon or a metal on the first resist pattern by making use of a coating method using a solution containing a solvent which is incapable of dissolving said first resist. A second resist film is formed on the substrate prior to forming the first resist film. A surface of the covering layer is etched until a surface of the first resist pattern is exposed, thereby allowing said covering film to be selectively left remain in an opened portion of the first resist pattern; then a second resist pattern is formed by etching the first resist pattern and the second resist pattern with the residual covering layer being employed as a mask.

"IBM Technical Disclosure Bulletin", volume 32, number 5B of October 1989, discloses a photo-etching process where an imageable material is applied on a material to be patterned. The material is then exposed and developed to form a pattern. A complementary material is then formed on top of the imageable material and hardened to form a material with different characteristics than the imageable material. The complementary material is used as a mask to facilitate removal of the imageable layer by ion etching.

Document "Microelectronic Engineering 61-62 (2002)" - ELSEVIER - pages 407-413 discloses a process of forming a pattern on a substrate by using a transparent mold which is pressed onto a liquid material placed on the substrate. The material is then solidified by use of UV radiation.

It is desired, therefore, to improve the throughput of micro-fabrication techniques while minimizing transfer distortions in patterns formed by these techniques.

SUMMARY OF THE INVENTION

The present invention provides a method according to claim 1. The method involves creating a multi-layered structure by forming, on the substrate, a patterned layer having protrusions and recessions employing imprint lithography. Formed upon the patterned layer is a conformal layer, with the multi-layered structure having a crown surface facing away from the substrate. Portions of the multi-layered structure are removed to expose regions of the substrate in superimposition with the protrusions, while forming a hard-mask in areas of the crown surface in superimposition with the recessions. In an exemplary embodiment, the patterned layer is formed from a substantially silicon-free polymerizable fluid employing imprint lithography techniques to form a silicon-free polymerized layer. The conformal layer is formed from a silicon-containing polymerized fluid and has a normalization surface that faces away from said substrate. Portions of the silicon-containing polymerized layer are removed employing a blanket etch to define a crown surface with the protrusions in the silicon-free polymerized layer being exposed. Then the crown surface is subjected to an anisotropic oxygen plasma etch that creates a hard mask in the regions of the crown surface in superimposition with the recessions, while removing the protrusions and segments of the silicon-free containing layer in superimposition therewith to expose the substrate. As a result of this process, patterning time is reduced while maintaining precise control over the dimensions in the pattern formed. These and other embodiments are described herein.

BRIEF DESCRIPTION OF THE DRAWINGS

Fig. 1 is a perspective view of a lithographic system in accordance with the present invention;
Fig. 2 is a simplified elevation view of a lithographic system, shown in Fig. 1, employed to create a patterned imprinting layer in accordance with the present invention;
Fig. 3 is a simplified representation of material from which a patterned imprinting layer, shown in Fig. 2, is comprised before being polymerized and cross-linked in accordance with the present invention;
Fig. 4 is a simplified representation of cross-linked polymer material into which the material shown in Fig. 3 is transformed after being subjected to radiation in accordance with the present invention;
Fig. 5 is a simplified elevation view of an imprint device spaced-apart from the patterned imprinting layer, shown in Fig. 1, after patterning in accordance with the present invention;
Fig. 6 is a simplified elevation view of formation of a multi-layered structure on a solidified imprinting layer, shown in Fig. 5, by deposition of a conformal layer, adjacent to the patterned imprinting layer, employing a mold in accordance with one embodiment of the present invention;
Fig. 7 is a simplified elevation view after a blanket etch of the multi-layered structure, shown in Fig. 6, to format a crown surface in the conformal layer with portions of the patterned imprinting layer being exposed in accordance with one embodiment of the present invention;
Fig. 8 is a simplified elevation view of the multi-layered structure, shown in Fig. 7, after subjecting the crown surface to an anisotropic etch to expose regions of a substrate in accordance with the present invention;
Fig. 9 is a simplified elevation view of a multi-layered structure after deposition of a conformal layer in accordance with an alternate embodiment of the present invention;
Fig. 10 is a simplified elevation view showing planarization of a conformal layer employing a planarized mold in accordance with an alternate embodiment of the present invention;
Fig. 11 is a simplified plan view of a radiation source employed in the lithographic system shown in Fig. 1, depicting dual radiation sources;
Fig. 12 is a simplified plan view of a radiation source employed in the lithographic system shown in Fig. 1, depicting single radiation source;
Fig. 13 is a cross-sectional view of a substrate shown in Figs. 1, 2, 5, 6, 7 and 8 showing an infra-red absorption layer ;
Fig. 14 is a cross-sectional view of as substrate shown in Figs. 1, 2, 5, 6, 7 and 8 showing an alternate infra-red absorption layer ;
Fig. 15 is a cross-section view showing a release layer and a planarization layer that may be employed in accordance with the present invention; and
Fig. 16 is a cross-section view showing a release layer applied to a planarization mold shown in Fig. 14.

DETAILED DESCRIPTION OF THE INVENTION

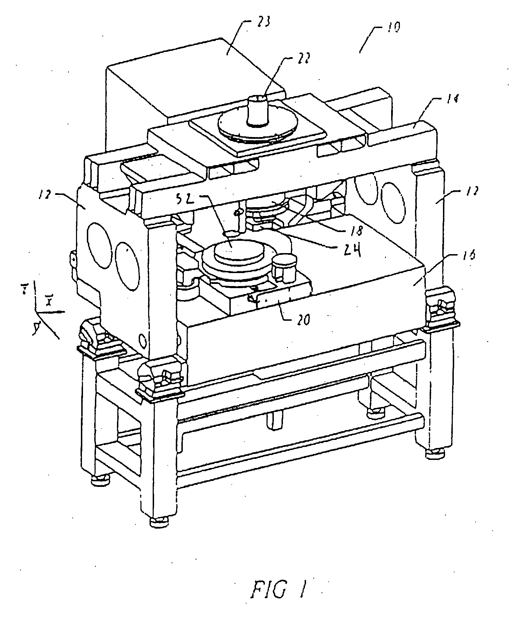

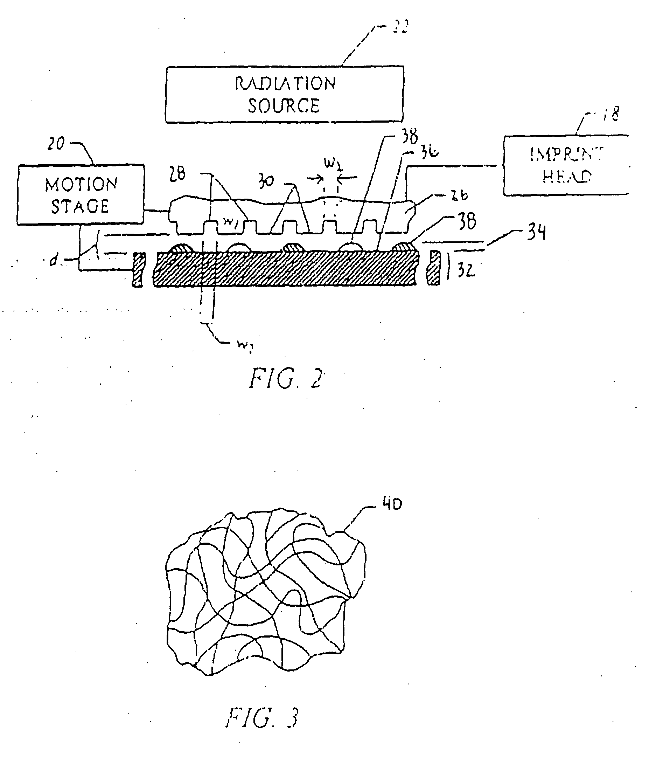

Fig. 1 depicts a lithographic system 10 in accordance with the present invention that includes a pair of spaced-apart bridge supports 12 having a bridge 14 and a stage support 16 extending therebetween. Bridge 14 and stage support 16 are spaced-apart. Coupled to bridge 14 is an imprint head 18, which extends from bridge 14 toward stage support 16. Disposed upon stage support 16 to face imprint head 18 is a motion stage 20. Motion stage 20 is configured to move with respect to stage support 16 along X and Y axes and may provide movement along the Z axis as well. A radiation source 22 is coupled to system 10 to impinge actinic radiation upon motion stage 20. As shown, radiation source 22 is coupled to bridge 14 and includes a power generator 23 connected to radiation source 22.
Referring to both Figs. 1 and 2, connected to imprint head 18 is a template 24 having a patterned mold 26 thereon. Patterned mold 26 includes a plurality of features defined by a plurality of spaced-apart recesses 28 and projections 30. Projections 30 have a width $W_1$, and recesses 28 have a width $W_2$, both of which are measured in a direction that extends transversely to the Z axis. The plurality of features defines an original pattern that forms the basis of a pattern to be transferred into a substrate 32 positioned on motion stage 20. To.that end, imprint head 18 is adapted to move along the Z axis and vary a distance "d" between patterned mold 26 and substrate 32. Alternatively, or in conjunction with imprint head 18, motion stage 20 may move template 24 along the Z-axis. In this manner, the features on patterned mold 26 may be imprinted into a flowable region of substrate 32, discussed more fully below. Radiation source 22 is located so that patterned mold 26 is positioned between radiation source 22 and substrate 32. As a result, patterned mold 26 is fabricated from material that allows it to be substantially transparent to the radiation produced by radiation source 22. An exemplary system is available under the trade name IMPRIO 100™ from Molecular Imprints, Inc. having a place of business at 1807-C Braker Lane, Suite 100, Austin, Texas 78758. The system description for the IMPRIO 100™ is available at www.molecularimprints.com and is incorporated herein by reference.

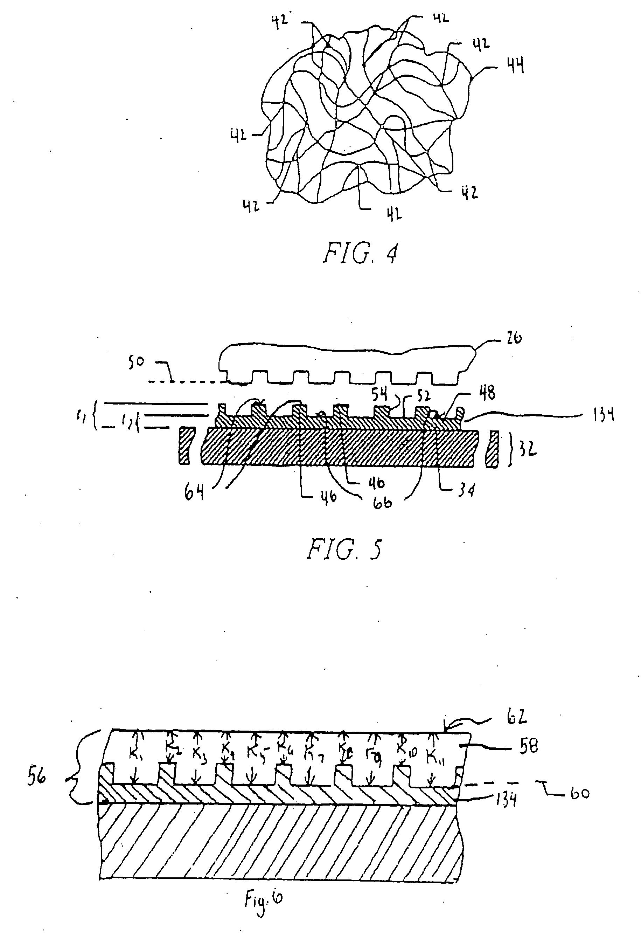

Referring to both Figs. 2 and 3, a flowable region, such as an imprinting layer 34, is disposed on a portion of surface 36 that presents a substantially planar profile. In the present embodiment, the flowable region is deposited as a plurality of spaced-apart discrete droplets 38 of material 40 on substrate 32, discussed more fully below. Material 40 is substantially silicon-free and may be selectively polymerized and cross-linked to record an.inverse of the original pattern therein, defining a recorded pattern. Material 40 is shown in Fig. 4 as being cross-linked at points 42, forming cross-linked polymer material 44.

Referring to Figs. 2, 3 and 5, the pattern recorded in imprinting layer 34 is produced, in part, by mechanical contact with patterned mold 26. To that end, the distance "d" is reduced to allow imprinting layer 34 to come into mechanical contact with patterned mold 26, spreading droplets 38 so as to form imprinting layer 34 with a contiguous formation of material 40 over surface 36. In one embodiment, distance "d" is reduced to allow sub-portions 46 of imprinting layer 34 to ingress into and fill recesses 28.

In the present embodiment, sub-portions 48 of imprinting layer 34 in superimposition with projections 30 remain after the desired, usually minimum distance "d", has been reached, leaving sub-portions 46 with a thickness $t_1$, and sub-portions 48 with a thickness, $t_2$. Thickness $t_2$ is referred to as a residual thickness. Thicknesses "$t_1$" and "$t_2$" may be any thickness desired, dependent upon the application. The total volume contained in droplets 38 may be such so as to minimize, or avoid, a quantity of material 40 from extending beyond the region of surface 36 in superimposition with patterned mold 26, while obtaining desired thicknesses $t_1$ and $t_2$.

Referring to Figs. 2, 3, and 4, after a desired distance "d" has been reached, radiation source 22 produces actinic radiation that polymerizes and crosslinks material 40, forming cross-linked polymer material 44. As a result, the composition of imprinting layer 34 transforms from material 40 to material 44, which is a solid. Specifically, material 44 is solidified to form solidified imprinting layer 134 with a side having a shape that conforms to a shape of a surface 50 of patterned mold 26, shown more clearly in Fig. 5. As a result, solidified imprinting layer 134 is formed having recessions 52 and protrusions 54. After formation of solidified imprinting layer 134, distance "d" is increased so that patterned mold 26 and solidified imprinting layer 134 are spaced-apart. Typically, this process is repeat several times to pattern different regions (not shown) of substrate 32, referred to as a step and repeat process. An exemplary step and repeat process is disclosed in published United States patent application number 20040008334, which assigned to assignee of the present invention.

Referring to Figs. 1, 2 and 3, the characteristics of material 40 are important to efficiently pattern substrate 32 in light of the unique deposition process employed. As mentioned above, material 40 is deposited on substrate 32 as a plurality of discrete and spaced-apart droplets 38. The combined volume of droplets 38 is such that the material 40 is distributed appropriately over an area of surface 36 where imprinting layer 34 is to be formed. In this fashion, the total volume of imprinting material 40 in droplets 38 defines the distance "d", to be obtained so that the total volume occupied by the material 40 in the gap defined between patterned mold 26 and the portion of substrate 32 in superimposition therewith once the desired distance "d" is reached is substantially equal to the total volume of material 40 in droplets 38. As a result, imprinting layer 34 is spread and patterned concurrently, with the pattern being subsequently set by exposure to radiation, such as ultraviolet radiation. To facilitate the deposition process, it is desired that material 40 have certain characteristics to provide rapid and even spreading of material 40 in droplets 38 over surface 36 so that the all thicknesses $t_1$ are substantially uniform and all residual thicknesses $t_2$ are substantially uniform.

An exemplary composition for material 40 is silicon-free and consists of the following:

COMPOSITION 1

isobornyl acrylate

n-hexyl acrylate

ethylene glycol diacrylate

2-hydroxy-2-methyl-1-phenyl-propan-1-one

In COMPOSITION 1, isobornyl acrylate comprises approximately 55% of the composition, n-hexyl acrylate comprises approximately 27%, ethylene glycol diacrylate comprises approximately 15% and the initiator 2-hydroxy-2-methyl-1-phenyl-propan-1-one comprises approximately 3%. The initiator is sold under the trade name DAROCUR® 1173 by CIBA® of Tarrytown, New York. The above-identified composition also includes stabilizers that are well known in the chemical art to increase the operational life of the composition. To provide suitable release properties, COMPOSITION 1 may be employed with a template treated to have a mold surface that is hydrophobic and/or low surface energy, e.g., an a priori release layer.

Referring to Figs. 3 and 5, to improve the release properties of patterned mold 26 and solidified imprinting layer 134 and to ensure that solidified imprinting layer 134 does not adhere to patterned mold 26, an additive may be included in COMPOSITION 1. To that end, material 40 may include, as an additive, a surfactant. For purposes of this invention a surfactant is defined as any molecule, one tail of which is hydrophobic. Surfactants may be either fluorine containing, e.g., include a fluorine chain, or may not include any fluorine in the surfactant molecule structure. An exemplary surfactant is available under the trade name ZONYL® FSO-100 from DUPONT™ that has a general structure of $R_1R_2$ where $R_1 = F(CF_2CF_2)_Y$, with y being in a range of 1 to 7, inclusive and $R_2 = CH_2CH_2O(CH_2CH_2O)_XH$, where X is in a range of 0 to 15, inclusive. This provides material 40 with the following composition:

COMPOSITION 2

isobornyl acrylate

n-hexyl acrylate

ethylene glycol diacrylate

2-hydroxy-2-methyl-1-phenyl-propan-1-one

$R_fCH_2CH_2O(CH_2CH_2O)_XH$,

The ZONYL® FSO-100 additive comprises less than 1% of the composition, with the relative amounts of the remaining components being as discussed above with respect to COMPOSITION 1. However, the percentage of ZONYL® FSO-100 may be greater than 1%.

Referring to Figs. 5 and 6, to facilitate transferring of the pattern in patterned mold 26 into substrate 32, a multi-layered structure 56 is generated by formation of a silicon-containing conformal layer 58 adjacent to solidified imprinting layer 134. To that end, silicon-containing material is deposited adjacent to solidified imprinting layer 134. Specifically, a silicon-containing material may be deposited adjacent to solidified imprinting layer 134 using any known technique to form conformal layer 58, such as the technique discussed above with respect to deposition of material 40. Alternatively, the silicon-containing material may be deposited adjacent to solidified imprinting layer 134 employing spin-coating techniques.

In an exemplary technique for forming conformal layer 58, silicon-containing material is deposited adjacent to solidified imprinting layer 134 using spin-coating techniques and subsequently thermally curing the silicon-containing material to form conformal layer 58. To that end, exemplary material that may be employed to form conformal layer 58 includes silicone resin, a cross-linking agent, a catalyst, and a solvent.

The silicone resin is process compatible, satisfying ionic, purity, and by-product contamination requirements desired. The cross-linking agent is included to cross-link the silicone resin, providing conformal layer 58 with the properties to record a pattern thereon having very small feature sizes, i.e., on the order of a few nanometers. To that end, the catalyst is provided to produce a condensation reaction in response to thermal energy, e.g., heat, causing the silicone resin and the cross-linking agent to polymerize and cross-link, forming a cross-linked polymer material. The solvent selected is compatible with the silicone resin and represents the remaining balance of the silicon-containing material. It is desired that the solvent minimize, if not avoid, causing distortions in solidified imprinting layer 134 due, for example, to swelling of solidified imprinting layer 134.

The silicone resin can be any alkyl and/or aryl substituted polysiloxane, copolymer, blend or mixture thereof. Examples of a silicone resin include ultraviolet (UV) curable sol-gels, UV curable epoxy silicone, UV curable acrylate silicone, and UV curable silicone via thiolene chemistry; and non-cured materials such as hydrogen silsesquioxane, and poly(meth)acrylate/siloxane copolymers. Preferably, a hydroxyl-functional polysiloxane is used such as a hydroxyl-functional organo-siloxane, with examples of organo-siloxanes including methyl, phenyl, propyl and their mixtures. The silicone resin may be present in the silicon-containing composition in amounts of approximately 2 to 40% by weight, depending on the thicknesses desired for conformal layer 58. An exemplary example of a hydroxyl-functional polysiloxane used in the present invention is a silicon T-resin intermediate available from Dow Corning® (Midland; Michigan) under the trade name Z-6018.

The cross-linking agent is a compound that includes two or more polymerizable groups. The cross-linking agent may be present in the silicon-containing composition in amounts of approximately 2 to 50% by weight in relation to the quantity of silicone resin present. Typically, the cross-linking agent is present in the silicon-containing composition in an amount of approximately 20 to 30%. An exemplary example of a cross-linking agent used in the present invention is a hexamethoxymethylmelamine(HMMM) based aminoplast cross-linking agent available from Cytec Industries, Inc. (West Paterson, New Jersey) under the trade name CYMEL 303ULF.

The catalyst may be any component that catalyzes a condensation reaction. Suitable catalysts may include, but are not limited to, acidic compounds such as sulfonic acid. The catalyst may be present in the silicon-containing material in amounts of approximately 0.05% to 5% by weight in relation to the silicone resin present. Typically, the catalyst is present in the silicon-containing material in an amount of approximately 1 to 2%. An exemplary example of a catalyst used in the present invention is toluenesulfonic acid available from Cytec Industries, Inc. (West Paterson, New Jersey) under the trade name CYCAT 4040.

For the balance of the composition, a solvent is utilized. The solvent can be any solvent or combination of solvents that satisfies several criteria. As mentioned above, the solvent should not cause solidified imprinting layer 134 to swell. In addition, the evaporation rate of the solvent should be established so that a desired quantity of the solvent evaporates as a result of the spin-coating process while providing sufficient viscosity to facilitate planarization of silicon-containing material in furtherance of forming conformal layer 58. Suitable solvents may include, but are not limited to, alcohol, ether, a glycol or glycol ether, a ketone, an ester, an acetate and mixtures thereof. The solvent may be present in the silicon-containing material used to form conformal layer 58 in amounts of approximately 60 to 98% by weight, dependent upon the desired thicknesses of conformal layer 58. An exemplary example of a solvent used in the present invention is methyl amyl ketone available from Aldrich Co. (St. Louis, Missouri) under the trade name MAK.

In a further embodiment, the composition of conformal layer 58 is altered to include an epoxy-functional silane coupling agent to improve the cross-linking reaction and improve the rate of cross-linking. Examples of epoxy-functional silanes may include glycidoxymethyltrimethoxysilane, 3-glycidoxypropyltrihydroxysilane, 3-glycidoxypropyldimethylhydroxysilane, 3-glycidoxypropyltrimeth oxysilane, 2,3-epoxypropyltrimethoxysilane, and the like. The epoxy-functional silane may be present in conformal layer 58 in amounts of approximately 2 to 30% by weight of silicon-containing compound in relation to the silicone resin and typically in an amount of 5 to 10%. An exemplary example of epoxy-functional silane used in the present invention is gamma-glycidoxypropyltrimethoxysilane available from GE Silicone/OSi Specialty (Wilton, CT) under the trade name A187.

Exemplary compositions from which to form conformal layer 58 are as follows:

COMPOSITION 3

hydroxyl-functional polysiloxane hexamethoxymethylmelamine toluenesulfonic acid methyl amyl ketone

COMPOSITION 4

hydroxyl-functional polysiloxane

hexamethoxymethylmelamine

gamma-glycidoxypropyltrimethoxysilane

toluenesulfonic acid

methyl amyl ketone

In COMPOSITION 3, hydroxyl-functional polysiloxane comprises approximately 4% of the composition, hexamethoxymethylmelamine comprises approximately 0.95%, toluenesulfonic acid comprises approximately .05% and methyl amyl ketone comprises approximately 95%. In COMPOSITION 4, hydroxyl-functional polysiloxane comprises approximately 4% of the composition, hexamethoxymethylmelamine comprises approximately 0.7%, gamma-glycidoxypropyl-rimethoxysilane comprises approximately .25%, toluenesulfonic acid comprises approximately .05%, and methyl amyl ketone comprises approximately 95%.

Both COMPOSITIONS 3 and 4 are made up of at least 4% of the silicone resin. Upon curing, however, the quantity of silicon present in conformal layer 58 is at least 5% by weight and typically in a range of 20% or greater. Specifically, the quantity and composition of the solvent present in COMPOSITIONS 3 and 4 is selected so that a substantial portion of the solvent evaporates during spin-coating application of the COMPOSITION 3 or 4 on solidified imprinting layer 134. In the present exemplary silicon-containing material, approximately 90% of the solvent evaporates during spin-coating. Upon exposing the silicon-containing material to thermal energy, the remaining 10% of the solvent evaporates, leaving conformal layer 58 with approximately 20% silicon by weight.

An exemplary method of forming conformal layer 58 includes spinning-on approximately 4mL of the silicon-containing material deposited proximate to a center of solidified imprinting layer 134. To that end, substrate 32 is spun at 1000 rev/min for 1 min by placing substrate 32 on a hot plate. Thereafter, the silicon-containing material is subjected to thermal energy by baking at 150° C for 1 min. This produces the silicon-containing material from which conformal layer 58 is formed, with thickness variations of 20nm or less. Were it desired to increase the thickness of the solidified silicon-containing layer, e.g., to provide the solidified silicon-containing layer with a thickness of 200nm, the aforementioned spin-coating and curing processes are simply repeated. As a result, the solvent employed is selected so as not to remove, "wash away," silicon-containing material in a well-cured conformal layer 58.

Referring to Figs. 5 and 6, the spin-coating and curing processes, conformal layer 58 includes first and second opposed sides. First side 60 faces imprinting layer 134 and has a profile complementary to the profile of the imprinting layer 134. The second side faces away from imprinting layer 134 forming a normalization surface 62, which is substantially smooth and typically planar. In this manner, normalization surface 62 provides a solidified conformal layer 58 with a substantially normalized profile. It is believed that normalization surface 62 is provided with a smooth, e.g., substantially planar, topography by ensuring that COMPOSITIONS 3 and 4 have a glass transition temperature lower than the curing temperature. Specifically, it is desired that the temperature difference between the glass transition temperature and the curing temperature be sufficient to allow the silicon-containing material to reflow during curing to maximize smoothness, e.g., planarity of normalization surface 62 in a minimum amount of time. For example, the COMPOSITIONS 3 and 4 each have a glass transition temperature of approximately 50°C and a curing temperature of 150°C. As a result, of the topography of normalisation surface 62, the distances, $k_2$, $k_4$, $k_6$, $k_8$ and $k_{10}$, between the apex 64 of each of the protrusions 54 and normalization surface 62 are substantially the same. Similarly, the distance, $k_1$, $k_3$, $k_5$, $k_7$, $k_9$ and $k_{11}$ between a nadir surface 66 of each of the recessions 52 and normalization surface 62 are substantially the same.

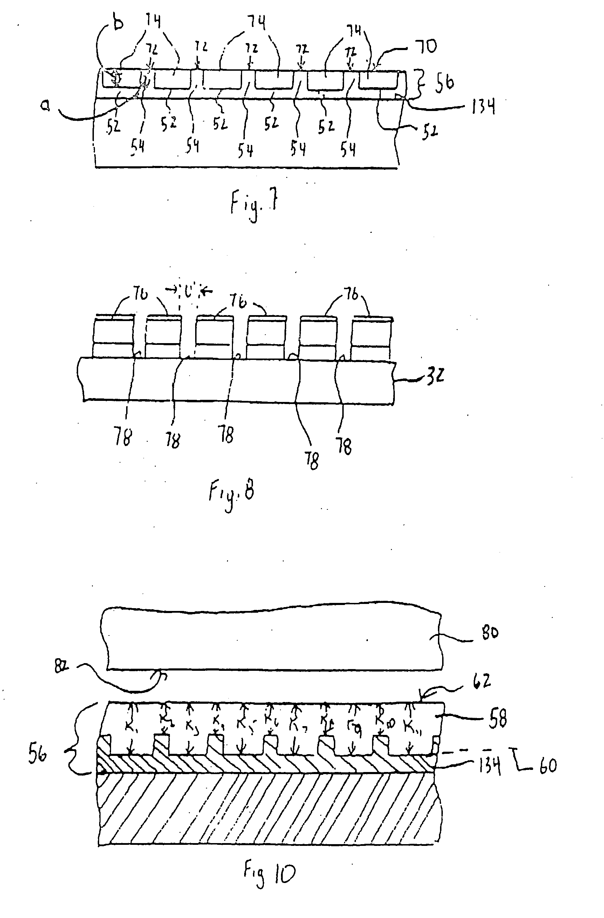

Referring to Figs. 6 and 7, after formation of the normalization surface 62, a blanket etch is employed to remove portions of conformal layer 58 to provide multi-layered structure 56 with a crown surface 70. For example and without limitation, the blanket etch may be achieved in a system available from LAM Research 9400SE obtained from Lam Research, Inc. of Fremont, California. In this manner, normalization surface 62 is subjected to an isotropic halogen reactive ion etch ("RIE") rich in fluorine, i.e., wherein at least one of the precursors was a fluorine-containing material, for example, and without limitation, a combination of $CHF_3$ and $O_2$. Other suitable halogen compounds include, for example, and without limitation, $CF_4$. It is desirable that oxygen be absent from the plasma chemistry. Normalization surface 62 is subjected to the blanket etch sufficient to expose crown surface 70.

Crown surface 70 is defined by an exposed surface 72 of each of protrusions 54 and upper surfaces of portions 74 that remain on conformal layer 58 after the blanket etch. The composition of conformal layer 58 is such that when the blanket etch is applied to conformal layer 58, crown surface 70 is provided with a substantially planar profile. That is, the thickness of protrusions 54, shown as "a", is substantially the same as the thickness of portions 74, shown as "b". An exemplary blanket etch may be a plasma etch process employing a fluorine-based chemistry.

Referring to Figs. 7 and 8, crown surface 70 is subjected to an anisotropic etch. The etch chemistry of the anisotropic etch is selected to maximize etching of protrusions 54 and the segments of imprinting layer 134, in superimposition therewith, while minimizing etching of the portions 74 in superimposition with recessions 52. In the present example, advantage was taken of the distinction of the silicon content between the imprinting layer 134 and the conformal layer 58. Specifically, employing an anisotropic plasma etch, e.g., an RIE plasma etch with an oxygen-based chemistry would create an in-situ hardened mask 76 in the regions of portions 74 proximate to crown surface 70. This results from the interaction of the silicon-containing polymerizable material with the oxygen plasma. As a result of the hardened mask 76 and the anisotropicity of the etch process, regions 78 of substrate 32 in superimposition with protrusions 54 are exposed. The width U' of regions 78 are optimally equal to width $W_2$, shown in Fig. 2.

Referring to Figs. 2, 7 and 8, the advantages of this patterning process are manifold. For example, the relative etch rate differential between portions 74 and exposed surfaces 72 facilitates, providing precise etch selectivity. As a result, the dimensional width U' of regions 78 may be precisely controlled, thereby reducing transfer distortions of the pattern into substrate 32. The resulting structure may be used as a mask to facilitate transfer of a pattern into substrate 32. Specifically, the etch differential provided by hardened mask 76 and the portions of solidified imprinting layer 134 in superimposition therewith would provide an etch differential in the presence of a blanket etch. In this manner, regions 78 of substrate 32 would etch sooner than regions of substrate 32 in superimposition with hardened mask 76. By properly selecting materials and etch chemistries, the relational dimensions between the differing features of the pattern eventually transferred into substrate 32 may be controlled as desired. For example, it was found beneficial to include an oxygen plasma etch after the fluorine etch and before the oxygen etch. Specifically, the etch selectivity during the oxygen plasma etch was improved. It is believed that residual fluorine is present on normalization surface 62 and that the Argon etch removes the residual fluorine, thereby further reducing the fluorine available during the oxygen plasma etch.

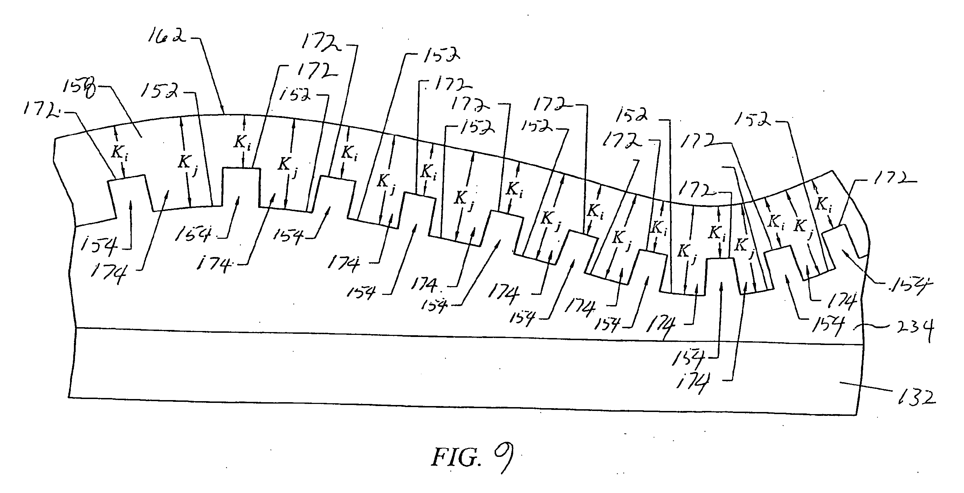

Referring to Figs. 1, 5 and 9 additionally, the control of dimensional width U' becomes relatively independent of residual thickness $t_2$. The rate at which the polymerizable fluid fills the pattern on mold 26 is inversely proportional to the cube of residual thickness $t_2$. As a result, residual thickness $t_2$ may be selected to maximize throughput without substantially increasing transfer distortions. Decoupling of the transfer distortions from residual thickness $t_2$ facilitates patterning non-planar surfaces without exacerbating transfer distortions. This is particularly useful when mold 26 is deformed due to external forces, such as typically occurs when varying the dimensions of mold 26 when effectuating magnification correction. As a result, deformation in mold patterned imprinting layer 234 may have a profile in which apex 172 of protrusions 154 are not coplanar and/or nadir surface 152 of recessions 174 are not coplanar.

To attenuate the transfer distortions that may result from this profile, conformal layer 158 is deposited so that that distances, $k_i$, between the apex 172 of each of the protrusions 154 and normalization surface 162 satisfies the following parameter:

$$\left| k_{i_{min}} - k_{i_{max}} \right| < t_3$$

where $k_{imin}$ is smallest value for $k_i$ and $k_{imax}$ is the greatest value for $k_i$ and $t_3$ is the height of protrusion 152 measured between apex 172 and nadir surface 152. Thus, the constraint on the normalization provided by normalization surface 162 may be relaxed so as not to require each value of $k_i$ to be substantially identical. To that end, conformal layer 158 may be applied by either spin-coating techniques or imprint lithography techniques. Thereafter, stage 20 is employed to move substrate 132 along the Z-axis to compress conformal layer 158 against a planar surface, such as a planarization mold (not shown). Alternatively, the planarization mold (not shown) may be moved against normalization surface 162 or both.

Finally, forming patterned imprinting layer 234 from a substantially silicon-free polymerizable fluid eases the cleaning process of mold 26, especially considering that mold 26 is often formed from fused silica.

It has been found that additional planarization may be desired when forming conformal layer 58, shown in Fig. 6, when features of sub ten micron dimension are to be transferred into substrate 32. To that end, as shown in Figs. 2 and 10, the silicon-containing material may be spun-on as discussed above with respect to forming conformal layer 58 or may be deposited as a plurality of droplets discussed above with respect to imprinting layer 34. After deposition of the silicon-containing material, a planarizing mold 80 having a substantially smooth, if not planar, surface 82 is employed to contact normalization surface 62, before solidification of the silicon-containing material in conformal layer 58. In this manner, conformal layer 58 is provided with a normalized surface with respect to solidified imprinting layer 134. This is typically achieved by providing an optical flat which has sufficient area to concurrently planarize all regions of substrate 32 that includes silicon-containing material employed to form normalization layer 58. Thereafter, the silicon-containing material in conformal layer 58 is solidified and planarized mold 80 is separated from conformal layer 58; and the normalization surface 62 may be processed as discussed above to pattern the same and transfer a pattern into substrate 32.

Referring to both Figs. 2, 6 and 11, it may be desired to implement a step and repeat planarization process when forming normalization layer 58. To that end, radiation source 22 may be selected to provide actinic radiation to both effectuate cross-linking using both infrared (IR) radiation and ultraviolet radiation. An exemplary radiation source 22 may include multiple sources each of which produces a single range of wavelengths of radiation and is shown including two radiation sources 84 and 86. Radiation source 84 may be any known in the art capable of producing IR radiation, and radiation source 86 may be any known in the art capable of producing actinic radiation employed to polymerize and cross-link material in droplets 38, such as UV radiation. Specifically, radiation produced by either of sources 84 and 86 propagates along optical path 88 toward substrate 32. A circuit (not shown) is in electrical communication with radiation sources 84 and 86 to selectively allow radiation in the UV and IR spectra to impinge upon substrate 32.

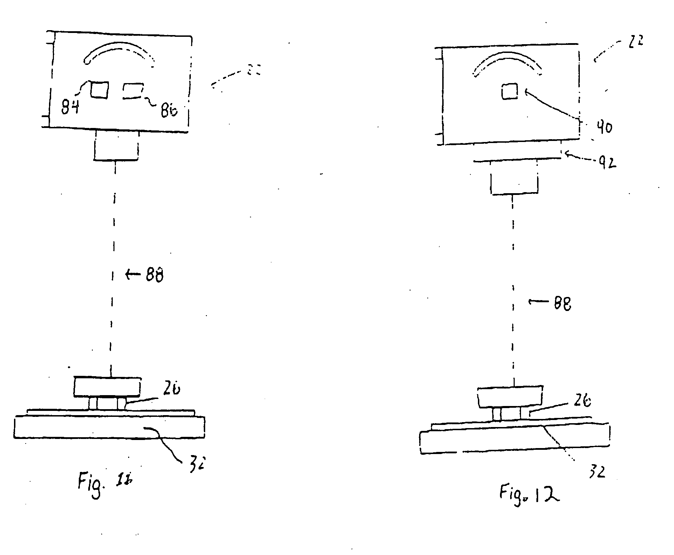

Referring to Fig. 12, alternatively, radiation source 22 may include a single radiation source that produces multiple ranges of wavelength, which may be selectively controlled to impinge upon substrate 32 sequentially or concurrently. An exemplary radiation source 22 consists of a single broad spectrum radiation source 90 that produces UV and IR radiation, which may consist of a mercury (Hg) lamp. To selectively impinge differing types of radiation upon substrate 32, a filtering system 92 is utilized. Filtering system 92 comprises a high pass filter (not shown) and a low pass filter (not shown), each in optical communication with radiation source 90. Filtering system 92 may position the high pass filter (not shown) such that optical path 88 comprises IR radiation or filtering system 92 may position the low pass filter (not shown) such that optical path 88 comprises UV radiation. The high pass and low pass filters (not shown) may be any known in the art, such as interference filters comprising two semi-reflective coatings with a spacer disposed therebetween. The index of refraction and the thickness of the spacer determine the frequency band being selected and transmitted through the interference filter. Therefore, the appropriate index of refraction and thickness of the spacer is chosen for both the high pass filter (not shown) and the low pass filter (not shown), such that the high pass filter (not shown) permits passage of IR radiation and the low pass filter (not shown) permits passage of UV radiation. A processor (not shown) is in data communication with radiation source 90 and filtering system 92 to selectively allow the desired wavelength of radiation to propagate along optical path 88. The circuit enables high pass filter (not shown) when IR radiation is desired and enables the low pass filter (not shown) when UV radiation is desired.

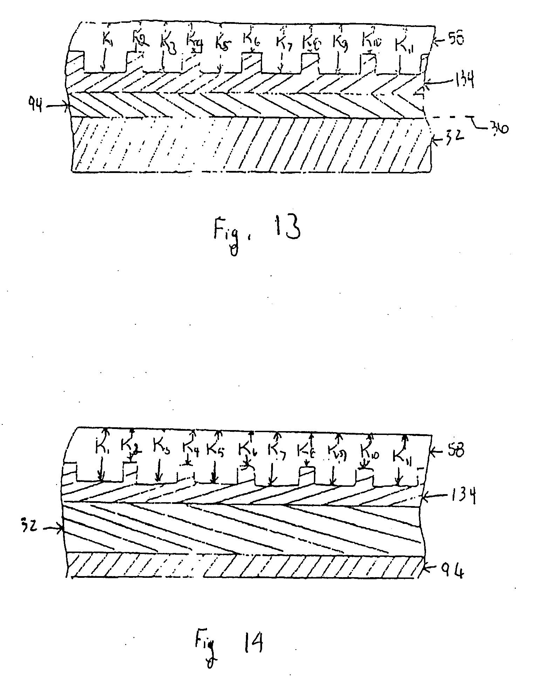

Referring to Fig. 13, substrate 32 may have one or more existing layers disposed thereon before deposition of imprinting layer 34. As a result, heating the silicon-containing material may be problematic, because the material from which the wafer is formed and/or the preexisting layers on the wafer, e.g., solidified imprinting layer 134, are substantially non-responsive to infrared radiation. As a result, very little energy transfer may occur, resulting in it being difficult to raise the temperature of the silicon-containing material sufficient to achieve cross-linking.

To facilitate cross-linking of the silicon-containing material in conformal layer 58, one of the layers included with substrate 32 may be an infrared absorption layer 94. Absorption layer 94 comprises a material that is excited when exposed to IR radiation and produces a localized heat source. Typically, absorption layer 94 is formed from a material that maintains a constant phase state during the heating process, which may include a solid phase state. Specifically, the IR radiation impinging upon absorption layer 94 causes an excitation of the molecules contained therein, generating heat. The heat generated in absorption layer 94 is transferred to the silicon-containing material via conduction through the wafer and/or any intervening layer of material thereon, e.g., absorption layer 94 may be disposed on surface 36 so as to be disposed between substrate 32 and solidified imprinting layer 134. As a result, absorption layer 94 and substrate 32 provide a bifurcated heat transfer mechanism that is able to absorb IR radiation and to produce a localized heat source sensed by the silicon-containing material in conformal layer 58. In this manner, absorption layer 94 creates a localized heat sources on surface 36. To that end, absorption layer 94 may be deposited using any known technique, including spin-coating, chemical vapor deposition, physical vapor deposition, atomic layer deposition and the like. Exemplary materials that may be formed from a carbon based PVD coating, organic thermo set coating with carbon black filler or molybdenum disulfide ($MoS_2$) based coating.

Referring to Fig. 14, absorption layer 94 may be disposed on a side of substrate 32 disposed opposite to solidified imprinting layer 134. As a result, absorption layer 94 may be permanently or removably attached. Exemplary materials that may be employed as absorption layer 94 include black nickel and anodized black aluminum. Also, black chromium may be employed as absorption layer 94. Black chromium is typically deposited as a mixture of oxides and is used as a coating for solar cells.

Furthermore, as shown in Fig. 2, patterned mold 26 may be fabricated from any material, such as, but not limited to, fused-silica, quartz, silicon, organic polymers, siloxane polymers, borosilicate glass, fluorocarbon polymers, metal, and combinations of the above. However, it the present embodiment, the actinic radiation propagates through patterned mold 26. Therefore, it is desired that patterned mold 26 be fabricated from material that is substantially transparent to the actinic radiation. The plurality of features on patterned mold 26 are shown as recesses 28 extending along a direction parallel to projections 30 that provide a cross-section of patterned mold 26 with a shape of a battlement. However, recesses 28 and projections 30 may correspond to virtually any feature required to create an integrated circuit and may be as small as a few tenths of nanometers.

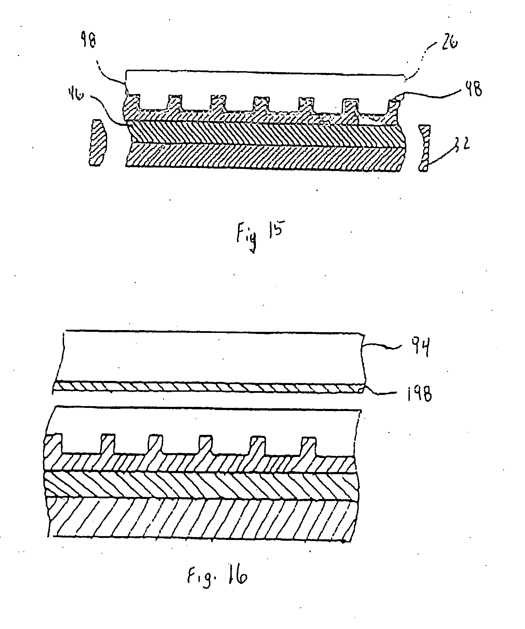

Referring to Figs. 2 and 15, similarly, it may be desirable to provide substrate 32 with a planarized surface upon which to forming imprinting layer 34. To that end, a primer layer 96 may be formed upon substrate 32. Primer layer 96 has proved beneficial when surface 36 of substrate 32 appears rough when compared to the features dimensions to be formed in imprinting layer 34. Additionally, it has been found beneficial to deposit primer layer 96 when forming imprinting layer 34 upon a previously disposed patterned layer present on substrate 32. Primer layer 96 may also functions, *inter alia*, to provide a standard interface with imprinting layer 34, thereby reducing the need to customize each process to the material from which substrate 32 is formed. In addition, primer layer 96 may be formed from an organic material with the same etch characteristics as imprinting layer 34. Primer layer 96 is fabricated in such a manner so as to possess a continuous, smooth, relatively defect-free surface that may exhibit excellent adhesion to imprinting layer 34. An exemplary material to use to form primer layer 96 is available from Brewer Science, Inc. of Rolla Missouri under the trade name DUV30J-6

Referring to Figs. 5 and 15, to reduce the probability that solidified imprinting layer 134 does not adhere to patterned mold 26, surface 50 may be treated with a low surface energy coating 98. Low surface energy coating 98 may be applied using any known process. For example, processing techniques may include chemical vapor deposition method, physical vapor deposition, atomic layer deposition or various other techniques, brazing and the like. In a similar fashion a low surface energy coating 198 may be applied to planarizing mold 94, shown in Fig. 16. Typically, the surfactant has a surface energy associated therewith that is lower than a surface energy of the polymerizable material in the layer. An exemplary material and process by which to form the aforementioned surfactant is discussed by Bender et al. in MULTIPLE IMPRINTING IN UV-BASED NANOIMPRINT LITHOGRAPHY:RELATED MATERIAL ISSUES, Microelectronic Engineering pp. 61-62 (2002). The low surface energy of the surfactant provides the desired release properties to reduce adherence of either imprinting layer 34 or conformal layer 58 to patterned mold 26. It should be understood that the surfactant may be used in conjunction with, or in lieu of, low surface energy coatings 98 and 198.

The embodiments of the present invention described above are exemplary. The scope of the invention should, therefore, be determined not with reference to the above description, but instead should be determined with reference to the appended claims.

## Claims

1. A method of patterning a substrate, said method comprising:

   forming, on said substrate (32), a patterned layer (134) having a shape with protrusions (54) and recessions (52) by:

   disposing, on said substrate (32), a polymerizable fluid composition (40),
   contacting said polymerizable fluid composition (40) with a surface of a mold (26), said surface having a profile complementary to said protrusions and said recessions, and subjecting said polymerizable fluid composition (40) to conditions to polymerize said polymerizable fluid composition, forming polymerized patterned layer (134);

   **characterized by** the fact of comprising transferring an inverse of said shape into said substrate by:

   forming, upon said patterned layer (134), a conformal layer (58), to create a multi-layered structure (56) having a crown surface (70) facing away from said substrate; and selectively removing portions of said multilayered structure (58) to expose regions (78) of said substrate in superimposition with said protrusions (54) while forming a hard mask (76) in areas of said crown surface in superimposition with said recessions (52).

2. The method as recited in claim 1 wherein forming said patterned layer (134) further includes providing said protrusions (54) with an apex and a height and forming said conformal layer (58) further includes providing said conformal layer with a normalization surface (62) spaced apart from one apex a minimum distance and spaced-apart from an additional apex a maximum distance with said height being greater than a difference between said maximum distance and said minimum distance.

3. The method as recited in claim 1 wherein said patterned layer (134) is formed from an organic polymerizable material substantially free of silicon and said conformal layer (58) is formed from a silicon-containing polymerizable material.

4. The method as recited in claim 1 wherein said patterned layer (134) is formed from a material having a polymerizable compound and a surfactant having a surface energy that is less than a surface energy of said polymerizable compound.

5. The method as recited in claim 1 wherein said conformal layer (58) is formed from a material having a polymerizable compound and a surfactant having a surface energy that is lower than a surface energy of said polymerizable compound.

6. The method as recited in claim 1 wherein said conformal layer (58) is formed by:

   disposing, on said patterned layer (134), a polymerizable fluid composition, contacting said polymerizable fluid composition with a planarization mold (80; 94) having a substantially planar surface, and
   subjecting said polymerizable fluid composition to conditions to polymerize said polymerizable fluid composition.

7. The method as recited in claim 1 wherein forming said conformal layer (58) further includes spin-coating a polymerizable fluid on said patterned layer.

8. The method as recited in claim 1 further including depositing a primer layer (96) between said patterned layer (134) and said substrate (32).

9. The method as recited in claim 1 wherein said conformal layer is formed with a section having a normalization surface (62) disposed opposite to said patterned layer (134) and spaced-apart from said protrusions, the method further including removing portions of said section to expose said protrusions, defining said crown surface (70) and exposing said crown surface to an etch chemistry.

10. The method as recited in claim 9 wherein normalization surface (62) is subjected to blanket etch sufficient to remove portions of conformal layer (58) and expose crown surface (70), the crown surface (70) being defined by an exposed surface (72) of each of protrusions (54) and upper surfaces of portions (74) that remain of conformal layer (58) after the blanket etch.

11. The method as recited in claim 10 wherein crown surface (70) is subjected to an anisotropic etch selected to maximize etching of protrusions (54) and the segments of imprinting layer (134) in superimposition therewith, while minimizing etching of the portions (74) in superimposition with recessions (52).

**Patentansprüche**

1. Verfahren zum Mustern eines Substrats, das Verfahren umfassend:

   Bilden einer gemusterte Schicht (134) auf einem Substrat (32), die eine Formgebung mit Vorsprüngen (54) und Vertiefungen (52) aufweist, durch Aufbringen einer polymerisierbaren Flüssigkeitszusammensetzung (40) auf das Substrat (32),
   Berühren der polymerisierbaren Flüssigkeitszusammensetzung (40) mit einer Oberfläche einer Form (26), wobei die Oberfläche ein Profil aufweist, das zu den Vorsprüngen und Vertiefungen komplementär ist, und
   Aussetzen der polymerisierbaren Flüssigkeitszusammensetzung (40) gegenüber Bedingungen, um die polymerisierbare Flüssigkeitszusammensetzung zu polymerisieren, wobei eine polymerisierte gemusterte Schicht (134) gebildet wird; **gekennzeichnet dadurch, dass** das Verfahren Transferieren eines Inversen der Formgebung in das Substrat umfasst, durch:

      Bilden einer konformen Schicht (58) auf der gemusterten Schicht (134), um eine vielschichtige Struktur (56) zu erzeugen, die eine Kronenoberfläche (70) aufweist, die vom Substrat abgewandt ist; und
      Wahlweises Entfernen von Teilen der vielschichtigen Struktur (58), um Bereiche (78) des Substrats in Überlagerung mit den Vorsprüngen (54) bloßzulegen, während eine harte Maske (76) in Teilbereichen der Kronenoberfläche in Überlagerung mit den Vertiefungen (52) gebildet wird.

2. Verfahren nach Anspruch 1, wobei Bilden der gemusterten Schicht (134) weiter Bereitstellen der Vorsprünge (54) mit einem Gipfel und einer Höhe beinhaltet und Bilden der konformen Schicht (58) weiter Bereitstellen der konformen Schicht mit einer Normalisierungsoberfläche (62) beinhaltet, beabstandet von einem Gipfel in einer minimalen Distanz und beabstandet von einem zusätzlichen Gipfel in einer maximalen Distanz, wobei die Höhe größer ist, als eine Differenz zwischen der maximalen Distanz und der minimalen Distanz.

3. Verfahren nach Anspruch 1, wobei die gemusterte Schicht (134) aus einem organischen polymerisierbaren Material gebildet ist, das im Wesentlichen frei von Silizium ist und die konforme Schicht (58) aus einem Silizium beinhaltenden polymerisierbaren Material gebildet ist.

4. Verfahren nach Anspruch 1, wobei die gemusterte Schicht (134) aus einem Material gebildet ist, das eine polymerisierbare Verbindung und ein Tensid aufweist, das eine Oberflächenspannung aufweist, die geringer ist, als eine Oberflächenspannung der polymerisierbaren Verbindung.

5. Verfahren nach Anspruch 1, wobei die konforme Schicht (58) aus einem Material gebildet ist, das eine polymerisierbare Verbindung und ein Tensid aufweist, das eine Oberflächenspannung aufweist, die niedriger ist, als eine Oberflächenspannung der polymerisierbaren Verbindung.

6. Verfahren nach Anspruch 1, wobei die konforme Schicht (58) gebildet ist durch:

    Aufbringen einer polymerisierbaren Flüssigkeitszusammensetzung auf der gemusterten Schicht (134),
    Berühren der polymerisierbaren Flüssigkeitszusammensetzung mit einer Planarisierungsform (80; 94), die eine im Wesentlichen planare Oberfläche aufweist, und
    Aussetzen der polymerisierbaren Flüssigkeitszusammensetzung gegenüber Bedingungen, um die polymerisierbare Flüssigkeitszusammensetzung zu polymerisieren.

7. Verfahren nach Anspruch 1, wobei Bilden der konformen Schicht (58) weiter Spin-Coating einer polymerisierbaren Flüssigkeit auf die gemusterte Schicht beinhaltet.

8. Verfahren nach Anspruch 1, weiter beinhaltend Aufbringen einer Primer-Schicht (96) zwischen der gemusterten Schicht (134) und dem Substrat (35).

9. Verfahren nach Anspruch 1, wobei die konforme Schicht mit einem Abschnitt gebildet wird, die eine Normalisierungsoberfläche (62) aufweist, die gegenüber von der gemusterten Schicht (134) und beabstandet von den Vorsprüngen angeordnet ist, wobei das Verfahren weiter Entfernen von Teilen des Abschnitts beinhaltet, um die Vorsprünge bloßzulegen, die Kronenoberfläche (70) definierend und die Kronenoberfläche einer Ätzchemie aussetzend.

10. Verfahren nach Anspruch 9, wobei die Normalisierungsoberfläche (62) Blanket-Ätzen ausgesetzt wird, ausreichend, um Teile der konformen Schicht (58) zu entfernen und die Kronenoberfläche (70) bloßzulegen, wobei die Kronenoberfläche (70) definiert wird durch eine bloßgelegte Oberfläche (72) jeder der Vorsprünge (54) und oberen Oberflächen der Teile (74), die von der konformen Schicht (58) nach dem Blanket-Ätzen übrig bleiben.

11. Verfahren nach Anspruch 10, wobei die Kronenoberfläche (70) anisotropem Ätzen ausgesetzt ist, ausgewählt, um das Ätzen der Vorsprünge (54) und der Segmente der Prägeschicht (134) in Überlagerung damit zu maximieren, während das Ätzen der Teile (74) in Überlagerung mit den Vertiefungen (52) minimiert wird.

## Revendications

1. Procédé pour former un motif sur un substrat, lequel procédé comprend :

    la formation, sur ledit substrat (32), d'une couche dotée d'un motif (134) ayant une forme avec des saillies (54) et des creux (52) par disposition, sur ledit substrat (32), d'une composition de fluide polymérisable (40), mise en contact de ladite composition de fluide polymérisable (40) avec une surface d'un moule (26), ladite surface ayant un profil complémentaire desdites saillies et desdits creux, et soumission de ladite composition de fluide polymérisable (40) à des conditions pour polymériser ladite composition de fluide polymérisable, formant une couche polymérisée dotée d'un motif (134) ;
    **caractérisé en ce qu'**il comprend le transfert d'un inverse de ladite forme dans ledit substrat par :

formation, sur ladite couche dotée d'un motif (134), d'une couche d'enrobage (58) pour créer une structure multicouche (56) ayant une surface supérieure (70) opposée audit substrat ; et

élimination sélective de parties de ladite structure multicouche (58) pour exposer des régions (78) dudit substrat en superposition avec lesdites saillies (54) tout en formant un masque dur (76) dans des zones de ladite surface supérieure en superposition avec lesdits creux (52).

2. Procédé selon la revendication 1, dans lequel la formation de ladite couche dotée d'un motif (134) comprend en outre l'opération consistant à doter lesdites saillies (54) d'un apex et d'une hauteur, et la formation de ladite couche d'enrobage (58) comprend en outre l'opération consistant à doter ladite couche d'enrobage d'une surface de normalisation (62) espacée d'une distance minimale d'un apex et espacée d'une distance maximale d'un apex supplémentaire, ladite hauteur étant supérieure à la différence entre ladite distance maximale et ladite distance minimale.

3. Procédé selon la revendication 1, dans lequel ladite couche dotée d'un motif (134) est formée à partir d'un matériau organique polymérisable pratiquement exempt de silicium et ladite couche d'enrobage (58) est formée à partir d'un matériau polymérisable contenant du silicium.

4. Procédé selon la revendication 1, dans lequel ladite couche dotée d'un motif (134) est formée à partir d'un matériau ayant un composé polymérisable et un tensioactif ayant une énergie de surface qui est inférieure à l'énergie de surface dudit composé polymérisable.

5. Procédé selon la revendication 1, dans lequel ladite couche d'enrobage (58) est formée à partir d'un matériau ayant un composé polymérisable et un tensioactif ayant une énergie de surface qui est inférieure à l'énergie de surface dudit composé polymérisable.

6. Procédé selon la revendication 1, dans lequel ladite couche d'enrobage (58) est formée par :

disposition, sur ladite couche dotée d'un motif (134), d'une composition de fluide polymérisable,

mise en contact de ladite composition de fluide polymérisable avec un moule de planarisation (80 ; 94) ayant une surface pratiquement plane, et

soumission de ladite composition de fluide polymérisable à des conditions pour polymériser ladite composition de fluide polymérisable.

7. Procédé selon la revendication 1, dans lequel la formation de ladite couche d'enrobage (58) comprend en outre la déposition par revêtement centrifuge d'un fluide polymérisable sur ladite couche dotée d'un motif.

8. Procédé selon la revendication 1, comprenant en outre la déposition d'une couche d'apprêt (96) entre ladite couche dotée d'un motif (134) et ledit substrat (32).

9. Procédé selon la revendication 1, dans lequel ladite couche d'enrobage est formée avec une section ayant une surface de normalisation (62) disposée à l'opposé de ladite couche dotée d'un motif (134) et espacée desdites saillies, lequel procédé comprend en outre l'élimination de parties de ladite section pour exposer lesdites saillies, en définissant ladite surface supérieure (70) et exposant ladite surface supérieure à une gravure chimique.

10. Procédé selon la revendication 9, dans lequel la surface de normalisation (62) est soumise à une gravure sous couverture suffisante pour éliminer des parties de la couche d'enrobage (58) et exposer la surface supérieure (70), la surface supérieure (70) étant définie par une surface exposée (72) de chacune des saillies (54) et des surfaces supérieures des parties (74) qui restent de la couche d'enrobage (58) après la gravure sous couverture.

11. Procédé selon la revendication 10, dans lequel la surface supérieure (70) est soumise à une gravure anisotropique sélectionnée de manière à maximiser la gravure de saillies (54) et les segments de couche d'impression (134) en superposition avec celles-ci, tout en minimisant la gravure des parties (74) en superposition avec les creux (52).

FIG 1

FIG. 2

FIG. 3

FIG. 4

FIG. 5

Fig. 6

Fig. 7

Fig. 8

Fig 10

FIG. 9

Fig. 11

Fig. 12

$K_1$  $K_2$  $K_3$  $K_4$  $K_5$  $K_6$  $K_7$  $K_8$  $K_9$  $K_{10}$  $K_{11}$

58

134

94

32

76

Fig. 13

$K_1$  $K_2$  $K_3$  $K_4$  $K_5$  $K_6$  $K_7$  $K_8$  $K_9$  $K_{10}$  $K_{11}$

58

134

32

94

Fig. 14

Fig 15

Fig. 16

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6334960 B, Willson
- US 2002036183 A
- US 20040008334 A

**Non-patent literature cited in the description**

- *IBM Technical Disclosure Bulletin,* October 1989, vol. 32 (5B
- Microelectronic Engineering. ELSEVIER, 2002, vol. 61-62, 407-413
- **BENDER et al.** MULTIPLE IMPRINTING IN UV-BASED NANOIMPRINT LITHOGRAPHY:RELATED MATERIAL ISSUES. *Microelectronic Engineering,* 2002, 61-62